# EUROPEAN PATENT APPLICATION

(11) **EP 4 683 471 A1**
(43) Date of publication of application: **21.01.2026**
(21) Application number: 24916589.5
(22) Date of filing: 26.11.2024
(51) Int. Cl.: H10K 30/88

(54) **ENCAPSULATING STRUCTURE FOR PEROVSKITE SOLAR CELL MODULE, AND APPLICATION THEREOF**

(30) Priority: 08.01.2024 CN 202410025731
(71) Applicant: Xi'an TJ-Solar New Energy Co., Ltd, Xianyang, Shaanxi 712046 (CN)
(72) Inventor: LI, Peizhou, Xianyang, Shaanxi 712046 (CN); HAN, Wei, Xianyang, Shaanxi 712046 (CN)
(74) Representative: Novagraaf Technologies
(86) International application number: PCT/CN2024/134596
(87) International publication number: WO 2025/148539

(57) **Abstract**

The present disclosure belongs to the technical field of photovoltaic modules, and relates to an encapsulation structure of a perovskite solar cell module and an application thereof. , thereby avoiding the failure of a perovskite solar cell module; and meanwhile, the area of an inorganic barrier layer is set to be greater than the area of the organic barrier layer, so that the purpose of blocking the moisture and oxygen from penetrating the organic barrier layer can be achieved, thereby improving the moisture and oxygen barrier capability of the perovskite solar cell module, prolonging the lifespan of the perovskite solar cell module, and facilitating to improve the reliability of the perovskite solar cell module in storage and use processes. Moreover, gaps between adjacent organic/inorganic barrier layers are not fully exposed to an external environment, thereby effectively blocking the lateral penetration of the water and oxygen, and thus the packaging effect is good.

## Description

### Technical Field

The present disclosure belongs to the technical field of photovoltaic modules, and relates to an encapsulation structure of a perovskite solar cell module and an application thereof.

### Background

Perovskite solar cells have attracted high attention from the academic community due to their characteristics of high photoelectric conversion efficiency, low cost, easy processing, and abundant resources, and the like. Although the efficiency of the perovskite solar cells is continuously improved, compared with conventional crystalline silicon or thin film solar cells, the existing perovskite solar cells often exhibit poor stability against moisture and oxygen, and in the ambient atmosphere, perovskite layers are easily decomposed or organic hole transport layers fail, resulting in rapid degradation of the performance of the solar cells. Therefore, an encapsulation technology has a significant impact on the service lives of the solar cells during use.

Conventional encapsulation technology of the perovskite solar cells cannot meet the requirements of the perovskite solar cells in terms of waterproofness, and a high-temperature operation is often required in an encapsulation process, which affects the performance of the perovskite solar cells. This imposes higher technical requirements for the encapsulation technology of the perovskite solar cells, and an encapsulation structure suitable for a perovskite solar cell module needs to be designed to solve the problems existing in the prior art.

### Summary

The objective of the present disclosure is to overcome the above shortcomings of the prior art, and to provide an encapsulation structure of a perovskite solar cell module and an application thereof, so as to maximally block moisture and oxygen in the air to improve the stability of a perovskite cell.

To achieve the above objective, the present disclosure provides the following technical solutions:
In one aspect, the present disclosure provides an encapsulation structure of a perovskite solar cell module, including:
a substrate for supporting a perovskite solar cell module;
the perovskite solar cell module formed above the substrate; and
an encapsulation structure formed on the perovskite solar cell module and including at least one inorganic barrier layer; or an encapsulation structure formed on the perovskite solar cell module and including a plurality of inorganic barrier layers and a plurality of organic barrier layers, which are alternately stacked, wherein an area of the inorganic barrier layer adjacent to an organic barrier layer is greater than an area of the current organic barrier layer; and an innermost layer and an outermost layer of the encapsulation structure are inorganic barrier layers; and
the encapsulation structure encapsulates an upper surface and a side surface of the perovskite solar cell module.

In a thickness direction of the perovskite solar cell module, there is an overlapping region between orthographic projections of the organic barrier layers; and two adjacent inorganic barrier layers are at least partially in contact with each other, and the inorganic barrier layers are stacked to form an inorganic layer stacked region.

In some embodiment, a thickness of the organic barrier layer is 10 nm to 100 µm, and a thickness of the inorganic barrier layer is 5 nm to 10 µm.

It should be noted that the thickness of the organic barrier layer is adaptively prepared according to actual encapsulation requirements, for example, 10 nm, 50 nm, 100 nm, 300 nm, 600 nm, 800 nm, 1000 nm, 2 µm, 10 µm, 30 µm, 50 µm, 60 µm, 80 µm, or 100 µm, and the like, which are not listed one by one; and the thickness of the inorganic barrier layer is adaptively prepared according to actual encapsulation requirements, and optional thicknesses are 5 nm, 20 nm, 40 nm, 80 nm, 100 nm, 300 nm, 500 nm, 700 nm, 900 nm, 1000 nm, 2 µm, 4 µm, 6 µm, 8 µm, 10 µm, and the like, which are not listed one by one.

In some embodiments, a total number of layers of the encapsulation structure is an odd number N, and 1 ≤ N ≤ 21. Specifically, the encapsulation structure includes any number of organic barrier layers and any number of inorganic barrier layers within the above range. Combinations of the organic barrier layers and the inorganic barrier layers vary depending on the degree of penetration resistance of oxygen, moisture, water vapor and/or chemicals. For example, a total number of the organic barrier layers and the inorganic barrier layers are 21 or less, for example, 1 layer (only the inorganic barrier layer), 3 layers , 5 layers, 7 layers, 9 layers, 11 layers, 13 layers, 15 layers, 17 layers, 19 layers, and 21 layers. Specifically, a five-layer encapsulation structure is alternately configured to be a first inorganic barrier layer, a first organic barrier layer, a second inorganic barrier layer, a second organic barrier layer and a third inorganic barrier layer from inside to outside.

It should be noted that in the encapsulation structure, the organic barrier layers and the inorganic barrier layers are alternately deposited, so as to supplement or strengthen the encapsulation effect of the perovskite solar cell module.

In some embodiments, the inorganic barrier layer encapsulates the perovskite solar cell module and at least part of the substrate.

In some embodiments, the organic barrier layer is a planar structure available for buffering and is made of a high molecular weight polymers or a resin material.

In some embodiments, a material of the inorganic barrier layer is selected from one or more of Al₂O₃, TiO₂, ZnO, ZrO₂, MgO, HfO₂, Ta₂O₅, Si₃N₄, AlN, SiNx, SiNO, SiO, SiO₂, SiOₓ, SiC or ITO.

In another aspect, the perovskite solar cell module provided in the present disclosure includes a conductive substrate (substrate), an electron transport layer, a perovskite layer, a hole transport layer, and an electrode.

In some specific embodiments, the conductive substrate includes an ITO glass substrate, but is not limited thereto.

In some specific embodiments, a material of the electron transport layer is selected from any one or more than two of TiO₂, SnO₂, ZnO, NiOₓ, PEDOT: PSS and PTAA, but is not limited thereto.

In some specific embodiments, a structural formula of the perovskite layer is any one of MAPbI₃, FAPbI₃ and FA_{0.8}Cs_{0.1}MA_{0.1}PbI_{2.9}Br_{0.1} (the structural formula of MA is CH₃NH³⁺, and the structural formula of FA is CH₄N²⁺), but is not limited thereto.

In some specific embodiments, the hole transport layer is any one or more than two of stratified structures prepared from nickel oxide, doped nickel oxide, cuprous iodide, cuprous thiocyanate, poly[bis (4-phenyl) (2,4,6-trimethylphenyl)amine] (PTAA), PEDOT: PSS, or Spiro-OMeTAD, but is not limited thereto.

In some specific embodiments, the electrode is one or more of gold (Au), silver (Ag), copper (Cu) and aluminum (Al), but is not limited thereto.

In some preferred embodiments, the perovskite solar cell is of a conventional structure (n-i-p type) or an inverted structure (p-i-n type).

In addition, the present disclosure further provides an application of the packaging structure in a solar cell, especially a perovskite solar cell.

Compared with the art known to inventors, the technical solutions provided in the present disclosure include the following beneficial effects:
The encapsulation structure provided in the present disclosure by extending the penetration path of moisture and oxygen from the edges into an organic barrier layer, the probability of their penetration into the organic barrier layer is effectively reduced, thereby avoiding the failure of the perovskite solar cell module; and meanwhile, the areas of the inorganic barrier layers are greater than the areas of the organic barrier layers, so that the purpose of blocking the moisture and oxygen from penetrating the organic barrier layers can be achieved, thereby improving the moisture and oxygen barrier capability of the perovskite solar cell module, prolonging the lifespan of the perovskite solar cell module, and facilitating to improve the reliability of the perovskite solar cell module in storage and use processes.

In addition, in the encapsulation structure provided in the present disclosure, gaps between adjacent organic barrier layers and inorganic barrier layers are not fully exposed to an external environment, thereby effectively blocking the lateral penetration of the moisture and oxygen, and thus the encapsulation effect is good.

### Brief Description of the Drawings

The drawings herein are incorporated into and constitute a part of the present specification, and serve to explain the principles of the present disclosure together with the specification.

To illustrate technical solutions in the embodiments of the present disclosure or in the prior art more clearly, a brief introduction on the drawings which are needed in the description of the embodiments or the prior art is given below. Apparently, for those ordinary skilled in the art, other drawings may also be obtained according to these drawings without any creative effort.
Fig. 1 illustrates a cross-sectional view of an encapsulation structure of a perovskite solar cell module provided in the present disclosure;
Fig. 2 illustrates a cross-sectional view of an encapsulation structure of a perovskite solar cell module provided in Embodiment 1 of the present disclosure;
Fig. 3 illustrates a cross-sectional view of an encapsulation structure of a perovskite solar cell module provided in Embodiment 2 of the present disclosure;
Fig. 4 illustrates a cross-sectional view of an encapsulation structure of a perovskite solar cell module provided in Comparative Example 1;
Fig. 5 illustrates a cross-sectional view of an encapsulation structure of a perovskite solar cell module provided in Comparative Example 2;
Fig. 6 illustrates time-varying curves of normalization efficiency of perovskite solar cell component encapsulation structures provided in Embodiment 1 and Comparative Examples 1-3; and
Fig. 7 illustrates time-varying curves of normalization efficiency of perovskite solar cell component encapsulation structures provided in Embodiments 1-4.
10. substrate; 20. perovskite solar cell module; 31. first inorganic barrier layer; 32. first organic barrier layer; 40. second inorganic barrier layer; 50. sealant; 60. glass cover plate; 301. inorganic layer stacked region.

### Detailed Description of the Embodiments

Exemplary embodiments will be described herein in detail, and examples of which are illustrated in the drawings. When the following description involves the drawings, unless otherwise represented, the same numbers in different drawings represent the same or similar elements. The implementations set forth in the following exemplary embodiments do not represent all implementations consistent with the present disclosure. Instead, they are merely examples consistent with some aspects of the present disclosure as detailed in the appended claims.

An encapsulation structure of a perovskite solar cell module provided in the present disclosure includes:
a substrate 10 for supporting a perovskite solar cell module 20;
the perovskite solar cell module 20 formed above the substrate 10; and
an encapsulation structure formed on the perovskite solar cell module 20 and including at least one inorganic barrier layer; or an encapsulation structure formed on the perovskite solar cell module 20 and including a plurality of inorganic barrier layers and a plurality of organic barrier layers, which are alternately stacked, wherein an area of the inorganic barrier layer adjacent to an organic barrier layer is greater than an area of the current organic barrier layer (that is, the area of the inorganic barrier layer is greater than the area of the organic barrier layer adjacent thereto); and an innermost layer and an outermost layer of the encapsulation structure are inorganic barrier layers; and
the encapsulation structure encapsulates an upper surface and a side surface of the perovskite solar cell module 20.

In some embodiments, in a thickness direction of the perovskite solar cell module 20, there is an overlapping region between orthographic projections of the organic barrier layers

In some embodiments, two adjacent inorganic barrier layers are at least partially in contact with each other, and the inorganic barrier layers are stacked to form an inorganic layer stacked region.

In some embodiments, a total number of layers of the encapsulation structure is an odd number N, and 1 ≤ N ≤ 21.

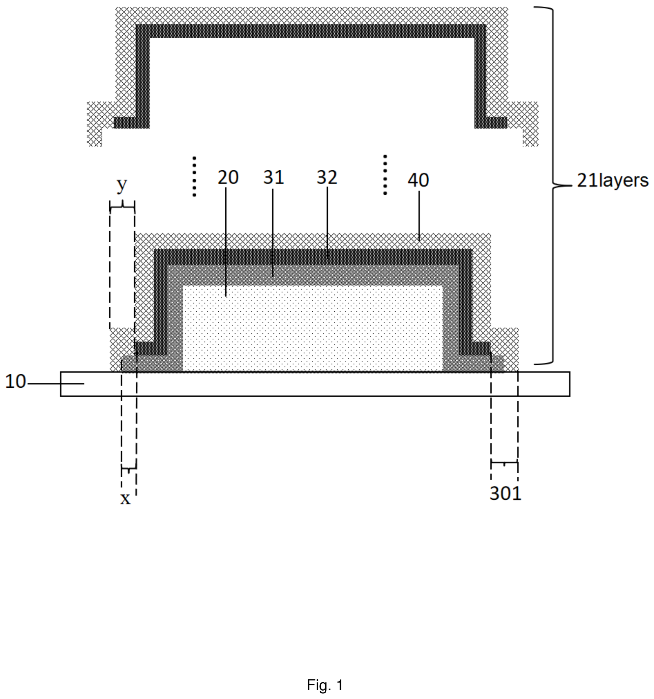

In the embodiment the total number of layers of the encapsulation structure is 21, as shown in Fig. 1.

In order to enable those skilled in the art to better understand the technical solutions of the present disclosure, the present disclosure will be further described in detail below with reference to the drawings and embodiments.

### Embodiment 1

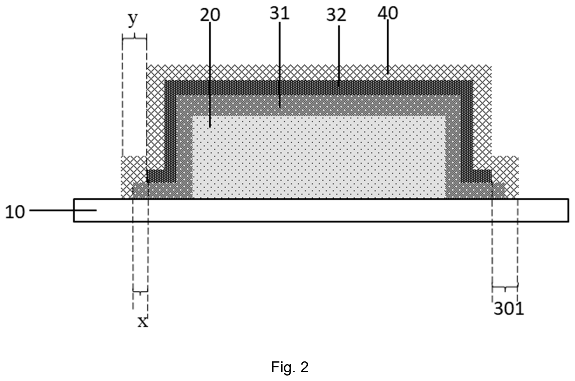

As shown in Fig. 1, the present embodiment provides an encapsulation structure of a perovskite solar cell module. As shown in Fig. 2, the encapsulation structure encapsulates an upper surface and a side surface of the perovskite solar cell module 20, and the encapsulation structure is a three-layer structure, which is formed by stacking a first inorganic barrier layer 31, a first organic barrier layer 32 and a second inorganic barrier layer 40 from inside to outside.

An area of the first inorganic barrier layer 31 adjacent to the first organic barrier layer 32 and an area of the second inorganic barrier layer 40 adjacent to the first organic barrier layer 32 are greater than an area of the first organic barrier layer 32 at the middle.

In the embodiment, a thickness of the first inorganic barrier layer 31 is 50 nm, a thickness of the second inorganic barrier layer 40 is 70 nm, and a thickness of the first organic barrier layer 32 is 20 µm.

Moreover, the first inorganic barrier layer 31 and the second inorganic barrier layer 40 are at least partially in contact with each other, and a part of the inorganic barrier layers in contact are stacked to form an inorganic layer stacked region 301.

An orthographic projection (a rectangle A) of the first inorganic barrier layer 31 on the substrate 10 and an orthographic projection (a rectangle B) of the first organic barrier layer 32, which is located above the first inorganic barrier layer 31 and is adjacent thereto, on the substrate 10 form a first "concentric-rectangular-frame" structure, and a distance between an inner ring and an outer ring of the first "concentric-rectangular-frame" structure is x;
an orthographic projection (a rectangle C) of the second inorganic barrier layer 40 on the substrate 10 and the orthographic projection (rectangle B) of the first organic barrier layer 32, which is located below the second inorganic barrier layer 40 and is adjacent thereto, on the substrate 10 form a second "concentric-rectangular-frame" structure, and a distance between an inner ring and an outer ring of the second "concentric-rectangular-frame" structure is y; and
both x and y are greater than 0.

In the embodiment, a material of the first organic barrier layer 32 is a high molecular weight polymers or a resin material.

In the embodiment, both a material of the first inorganic barrier layer 31 and a material of the second inorganic barrier layer 40 are selected from one or more of Al₂O₃, TiO₂, ZnO, ZrO₂, MgO, HfO₂, Ta₂O₅, Si₃N₄, AIN, SiNx, SiNO, SiO, SiO₂, SiOₓ, SiC or ITO.

### Embodiment 2

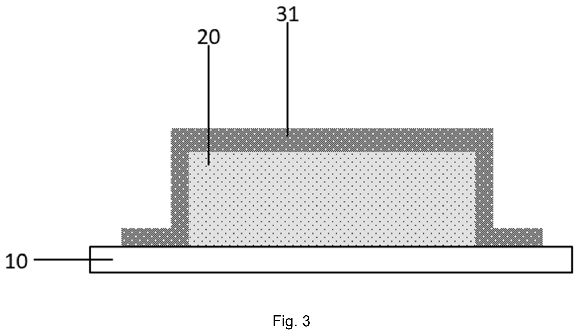

On the basis of Embodiment 1, the difference from Embodiment 1 lies that the encapsulation structure in the present embodiment is only the first inorganic barrier layer 31 disposed above the perovskite solar cell module 20, as shown in Fig. 3, and the thickness thereof is 200 nm.

### Embodiment 3

On the basis of Embodiment 1, the difference from Embodiment 1 lies that the encapsulation structure in the present embodiment is a five-layer structure, which is formed by stacking the first inorganic barrier layer 31, the first organic barrier layer 32, the second inorganic barrier layer 40, a second organic barrier layer and a third inorganic barrier layer from inside to outside.

In the embodiment, the thickness of the first inorganic barrier layer 31 is 40 nm, the thickness of the second inorganic barrier layer 40 is 70 nm, a thickness of the third inorganic barrier layer is 20 nm, the thickness of the first organic barrier layer 32 is 15 µm, and a thickness of the second organic barrier layer is 30 µm.

Specifically, in the thickness direction of the perovskite solar cell module 20, there is an overlapping region between the orthographic projection of the first organic barrier layer 32 and the orthographic projection of the second organic barrier layer.

Specifically, the first inorganic barrier layer 31 and the second inorganic barrier layer 40 are at least partially in contact with each other, the second inorganic barrier layer 40 and the third inorganic barrier layer are at least partially in contact with each other, and the first inorganic barrier layer 31, the second inorganic barrier layer 40 and third inorganic barrier layer are stacked to form the inorganic layer stacked region 301.

### Embodiment 4

On the basis of Embodiment 1, the difference from Embodiment 1 lies that the encapsulation structure in the present embodiment is a seven-layer structure, which is formed by stacking the first inorganic barrier layer 31, the first organic barrier layer 32, the second inorganic barrier layer 40, the second organic barrier layer, the third inorganic barrier layer, a third organic barrier layer and a fourth inorganic barrier layer from inside to outside.

In the embodiment, the thickness of the first inorganic barrier layer 31 is 20 nm, the thickness of the second inorganic barrier layer 32 is 50 nm, the thickness of the third inorganic barrier layer is 30 nm, a thickness of the fourth inorganic barrier layer is 30 nm, the thickness of the first organic barrier layer 40 is 10 µm, the thickness of the second organic barrier layer is 30 µm, and a thickness of the third organic barrier layer is 40 µm.

Specifically, in the thickness direction of the perovskite solar cell module 20, there are overlapping regions among the orthographic projection of the first organic barrier layer 40, the orthographic projection of the second organic barrier layer, and the orthographic projection of the third organic barrier layer.

Specifically, the first inorganic barrier layer 31 and the second inorganic barrier layer 40 are at least partially in contact with each other, the second inorganic barrier layer 40 and the third inorganic barrier layer are at least partially in contact with each other, the third inorganic barrier layer and the fourth inorganic barrier layer are at least partially in contact with each other, and the first inorganic barrier layer 31, the second inorganic barrier layer 40, the third inorganic barrier layer and the fourth inorganic barrier layer are stacked to form the inorganic layer stacked region 301.

### Comparative Example 1

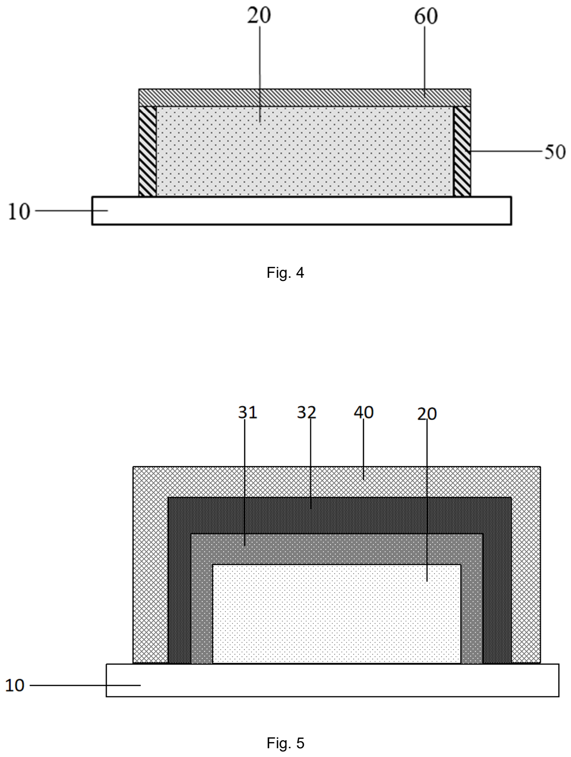

On the basis of Embodiment 1, the difference from Embodiment 1 lies that in the present comparative example, a glass cover plate 60 is disposed above the perovskite solar cell module, and a side surface thereof is encapsulated by a dedicated sealant 50 for perovskite solar cells, as shown in Fig. 4.

The sealant 50 is a colorless and transparent epoxy resin AB adhesive, which is prepared according to a mass ratio of A:B = 2: 1, A denotes an epoxy resin main agent, and B denotes a curing agent; and the sealant 50 has a width of 1000 µm and a thickness of 100 µm.

### Comparative Example 2

On the basis of Embodiment 1, the difference from Embodiment 1 lies that in the present comparative example, only an organic barrier layer with a thickness of 21 µm is disposed above the perovskite solar cell module.

### Comparative Example 3

On the basis of Embodiment 1, the difference from Embodiment 1 lies that in the present comparative example, the encapsulation structure above the perovskite solar cell module has no inorganic layer stacked region 301, as shown in Fig. 5.

In order to verify the effectiveness of the technical solutions provided in the present disclosure, a standard performance test is performed on the perovskite cell components disclosed in Embodiments 1-4 and the perovskite cell components provided in Comparative Examples 1-3, and the specific test process is as follows:
(1) Drawing a PCE-t curve (a time-varying curve of normalization efficiency), and using a sunlight simulator for measurement, wherein the illumination intensity of the sunlight simulator is 100 mA/cm², the experiment condition is illumination at an atmospheric pressure, the temperature is 20 °C, and the humidity is 30%.

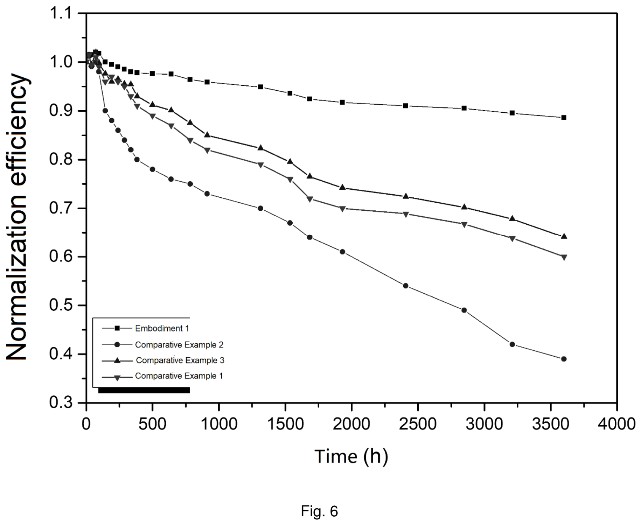

It can be seen from Fig. 6 that the perovskite solar cell component provided in Embodiment 1 still has more than 88% of initial power conversion efficiency after being placed in the air for 3600 h, the encapsulation structure in Comparative Example 1 only has 64% of the initial power conversion efficiency after being placed in the air for about 3600 h, the encapsulation structure in Comparative Example 2 only has 50% of the initial power conversion efficiency after being placed in the air for about 3600 h, the encapsulation structure in Comparative Example 3 only has 60% of the initial power conversion efficiency after being placed in the air for about 3600 h. This fully illustrates that the encapsulation effect of Embodiment 1 is better than that of Comparative Examples 1-3.

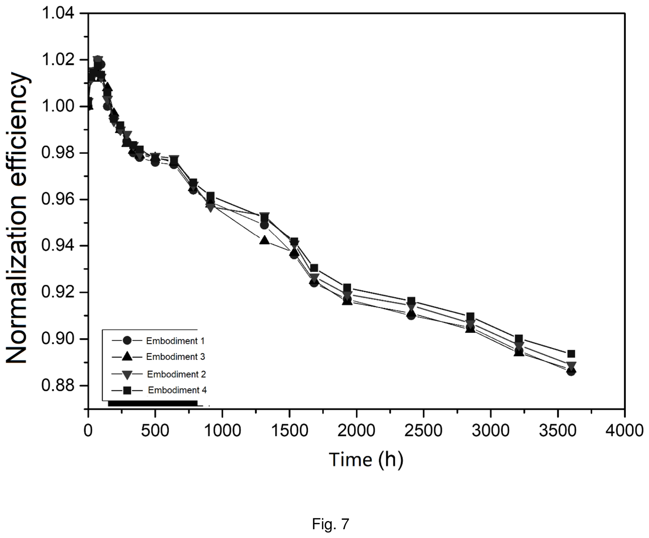

As shown in Fig. 7, the perovskite solar cell components prepared in Embodiments 1-4 have more than 88% of the initial power conversion efficiency after being placed in the air for 3600 h.

The above descriptions are only specific implementations of the present disclosure, so that those skilled in the art can understand or implement the present disclosure. Various modifications to these embodiments will be readily apparent to those skilled in the art, and the generic principles defined herein may be implemented in other embodiments without departing from the spirit or scope of the present disclosure.

It should be understood that the present disclosure is not limited to what has been described above, and that various modifications and changes may be made without departing from the scope thereof. The scope of the present disclosure is only limited by the appended claims.

## Claims

1. An encapsulation structure of a perovskite solar cell module, comprising:
a substrate for supporting a perovskite solar cell module;
the perovskite solar cell module (20) formed above the substrate (10); and
an encapsulation structure formed on the perovskite solar cell module (20) and comprising at least one inorganic barrier layer; or an encapsulation structure formed on the perovskite solar cell module (20) and comprising a plurality of inorganic barrier layers and a plurality of organic barrier layers, which are alternately stacked, wherein an area of the inorganic barrier layer adjacent to an organic barrier layer is greater than an area of the current organic barrier layer;
wherein the encapsulation structure encapsulates an upper surface and a side surface of the perovskite solar cell module (20); and
the perovskite solar cell module (20) comprises an electron transport layer, a perovskite layer, a hole transport layer and an electrode, and the perovskite solar cell module (20) is of a conventional structure or an inverted structure.

2. The encapsulation structure of the perovskite solar cell module as claimed in claim 1, wherein a total number of layers of the encapsulation structure is an odd number N, and 1 ≤ N ≤ 21.

3. The encapsulation structure of the perovskite solar cell module as claimed in claim 1, wherein an innermost layer and an outermost layer of the encapsulation structure are inorganic barrier layers.

4. The encapsulation structure of the perovskite solar cell module as claimed in claim 1, wherein in a thickness direction of the perovskite solar cell module (20), there is an overlapping region among orthographic projections of the organic barrier layers.

5. The encapsulation structure of the perovskite solar cell module as claimed in claim 1, wherein two adjacent inorganic barrier layers are at least partially in contact with each other, and the inorganic barrier layers are stacked to form an inorganic layer stacked region.

6. The encapsulation structure of the perovskite solar cell module as claimed in claim 1, wherein a thickness of the organic barrier layer is 10 nm to 100 µm, and a thickness of the inorganic barrier layer is 5 nm to 10 µm.

7. The encapsulation structure of the perovskite solar cell module as claimed in claim 1, wherein a material of the organic barrier layer is a high molecular weight polymers or a resin material.

8. The encapsulation structure of the perovskite solar cell module as claimed in claim 1, wherein a material of an inorganic barrier layer is selected from one or more of Al₂O₃, TiO₂, ZnO, ZrO₂, MgO, HfO₂, Ta₂O₅, Si₃N₄, AIN, SiNx, SiNO, SiO, SiO₂, SiOₓ, SiC or ITO.

9. The encapsulation structure of the perovskite solar cell module as claimed in claim 1, wherein an orthographic projection of an inorganic barrier layer on the substrate (10) and an orthographic projection of an organic barrier layer, which is located above the inorganic barrier layer and is adjacent thereto, on the substrate form a first "concentric-rectangular-frame" structure, and a distance between an inner ring and an outer ring of the first "concentric-rectangular-frame" structure is x;
the orthographic projection of the inorganic barrier layer on the substrate (10) and an orthographic projection of an organic barrier layer, which is located below an inorganic barrier layer and is adjacent thereto, on the substrate (10) form a second "concentric-rectangular-frame" structure, and a distance between an inner ring and an outer ring of the second "concentric-rectangular-frame" structure is y; and
both x and y are greater than 0.

10. An application of the packaging structure according to any of claims 1-9 in a perovskite solar cell.
